**Europäisches Patentamt**

**European Patent Office**

**Office européen des brevets**

(19)

(11) Numéro de publication : **0 500 454 A1**

(12)

# DEMANDE DE BREVET EUROPEEN

(21) Numéro de dépôt : **92400429.4**

(51) Int. Cl.⁵ : **B23K 1/20,** C23C 14/48

(22) Date de dépôt : **18.02.92**

(30) Priorité : **19.02.91 FR 9101955**

(43) Date de publication de la demande :
**26.08.92 Bulletin 92/35**

(84) Etats contractants désignés :
**AT BE CH DE DK ES FR GB GR IT LI LU NL PT SE**

(71) Demandeur : **NITRUVID**
**9, Rue Jean Poulmarch Zone Industrielle Duval**
**F-95100 Argenteuil (FR)**

(71) Demandeur : **META-CERAM**
**21, rue Georges Lebigot**
**F-94800 Villejuif (FR)**

(72) Inventeur : **Flegeau, Gérard**
**26, rue du Fer à Moulin**
**F-75005 Paris (FR)**
Inventeur : **Robelet, Marc**
**35 rue Robespierre**
**F-48240 Unieuk (FR)**

(74) Mandataire : **Martin, Jean-Paul et al**
**c/o CABINET LAVOIX 2, Place d'Estienne d'Orves**
**F-75441 Paris Cedex 09 (FR)**

(54) **Procédé pour réaliser une liaison par brasage entre deux pièces, notamment une pièce céramique et une pièce métallique, et ensemble soudé réalisé par ce procédé.**

(57)    Ce procédé consiste à assembler les pièces (2, 3) à braser en interposant entre leurs surfaces en contact, une brasure (4) constituée d'un métal ou d'un alliage métallique dont le point de fusion est à une température moins élevée que le point de fusion du matériau constituant les pièces à réunir, à élever la température de l'ensemble des pièces, afin de fondre la brasure, la brasure en fusion mouillant la surface en contact des pièces, à refroidir l'ensemble des pièces en contrôlant la température afin de solidifier la brasure pour réaliser un ensemble rigide avec les pièces ; on implante des ions dans une surface de contact (2a) d'au moins l'une des pièces (2, 3) à joindre, préalablement à l'assemblage des pièces et de la brasure, pour améliorer la mouillabilité de la brasure sur la surface de contact implantée, et obtenir une interface à composition graduée.

FIG.1

La présente invention concerne un procédé pour réaliser une liaison par brasage entre deux pièces et notamment une pièce en céramique et une pièce métallique, ainsi qu'un ensemble comportant une liaison rigide brasée obtenue par ce procédé.

Selon ce procédé, on assemble les pièces à braser en interposant entre leurs surfaces de contact une brasure constituée d'un métal ou d'un alliage métallique dont le point de fusion est à une température moins élevée que le point de fusion des matériaux constituant les pièces à réunir, on élève la température de l'ensemble des pièces, afin de fondre la brasure, la brasure en fusion mouillant la surface en contact des pièces, on refroidit l'ensemble des pièces en contrôlant la température afin de solidifier la brasure pour réaliser un ensemble rigide avec les pièces.

Il est connu de réaliser par brasure des liaisons céramique-métal.

Les céramiques pressées isostatiquement, de bonne qualité en densité, sont frittées pour former une pièce qui est ensuite, par exemple lorsque la céramique est une alumine, métallisée après frittage pour obtenir en surface des propriétés physico-chimiques permettant une mouillabilité de la brasure. Cette dernière est généralement un alliage tel que par exemple argent-cuivre, or-nickel, or-cuivre, ou uniquement un élément de ces alliages.

Bien que les brasures connues donnent satisfaction, les interfaces pièces-brasure de matériaux différents restent une difficulté de réalisation, particulièrement lorsqu'il y a des problèmes de mouillabilité entre la brasure fondue et la surface de contact des pièces à braser.

En effet, les liaisons telles que céramique-métal, réalisées avec une brasure, posent généralement des problèmes d'adhérence dûs aux propriétés physiques et chimiques très différentes et parfois incompatibles des matériaux en contact, à braser.

Le manque d'adhérence entre une brasure et un matériau est lié à un manque de mouillabilité (la mouillabilité étant un phénomène complexe) de la brasure fondue sur le matériau.

On a déjà proposé une métallisation préalable à la brasure des surfaces de contact des pièces à braser, constituant un dépôt en surface sous forme d'un film. Ce procédé présente l'inconvénient résidant dans une adhérence relativement faible du film, pouvant générer un décollement de la brasure. On a aussi proposé une métallisation dite "dure", préalable à la brasure, des surfaces de contact des pièces céramiques à braser, avec des métaux par exemple réfractaires, tels que le molybdène et le manganèse. Cette métallisation n'est pas utilisable pour des pièces ouvragées, donc sensibles aux contraintes thermiques. De même elle n'est pas utilisable pour des pièces d'oxydes métalliques ou autres matériaux ayant un point de fusion inférieur à la température de métallisation. En effet, la métallisation dite dure, consiste en une réduction des oxydes des métaux réfractaires à une température supérieure à 1300 °C, sous atmosphère contrôlée d'hydrogène, les oxydes étant préalablement déposés sous forme d'une poudre en suspension dans un milieu aqueux.

L'invention a pour but de remédier aux inconvénients exposés ci-dessus.

Conformément à l'invention, on implante des ions dans au moins une surface de contact d'une des pièces à braser préalablement à l'assemblage des pièces et de la brasure, pour améliorer la mouillabilité de la brasure sur la surface de contact implantée.

On modifie ainsi les propriétés physico-chimiques de la matrice des matériaux constituant les pièces, en surface et/ou dans le volume près de la surface, ce qui améliore le comportement de la brasure fondue sur la surface de contact des pièces, en améliorant sa mouillabilité sur la surface de contact implantée.

Suivant d'autres caractéristiques de l'invention :
– les ions implantés sont choisis parmi les ions Ti, Al, Cr, Mn, Fe, Co, Ni, Cu, Ag, Au, Zr.
– on implante les ions sur la surface de contact de pièces céramiques.
– on implante des ions sur la surface de contact de pièces constituées d'un cristal d'oxyde métallique.
– on implante les ions sur la surface de contact des pièces métalliques.
– les ions sont répartis majoritairement dans la matrice du matériau de la pièce implantée près de la surface de contact avec la brasure.
– les ions sont répartis d'une part dans la matrice du matériau de la pièce et en surface de la pièce pour former un film composé majoritairement des ions implantés.

L'invention concerne également un ensemble réalisé par la mise en oeuvre du procédé précité, composé de pièces brasées entre elles et notamment d'un ensemble composé d'une pièce en céramique, d'une pièce support de la pièce céramique en métal ou alliage métallique, les pièces étant liées rigidement entre elles par un emmanchement, dans lequel est insérée une brasure liant mécaniquement la pièce céramique et la pièce support.

D'autres particularités et avantages de l'invention appraitront au cours de la description qui va suivre, faite en référence aux dessins annexés qui en illustrent deux formes de réalisation à titre d'exemples non limitatifs.

La figure 1 est une vue en coupe transversale d'un ensemble composé de deux pièces brasées entre elles et qui peut être réalisé selon l'invention La figure 2 est un graphique représentant un premier mode possible de la répartition en densité des ions implantés sur la surface de contact d'une pièce, conformément à une forme de réalisation du procédé visé par l'invention.

La figure 3 et un graphique analogue à la Fig.2, représentant un second mode possible de répartition en densité des ions implantés, selon une seconde forme de réalisation du procédé visé par l'invention.

Le procédé selon l'invention permet de réaliser, par exemple, une liaison par brasure entre une pièce en céramique et une pièce métallique ou en alliage métallique, entre deux pièces céramiques ou encore entre deux pièces métalliques. La céramique peut être avantageusement remplacée par une pièce constituée d'un cristal d'oxyde métallique.

Pour améliorer la mouillabilité de la brasure fondue sur le matériau, on implante sur les surfaces de contact des pièces à braser, avant l'assemblage desdites pièces avec la brasure, des ions spécifiques, lorsqu'il est reconnu que la brasure et la surface de contact de la pièce traitée sont compatibles, ont une bonne mouillabilité et une bonne adhérence.

L'implantation ionique selon l'invention peut être exécutée au moyen de techniques diverses, connues en soi.

Tous ions modifiant et améliorant les propriétés physiques de la mouillablité des surfaces de contact avec la brasure peuvent convenir.

Il est possible, par implantation ionique, d'introduire dans la surface d'une céramique, un élément par exemple métallique, comme celui qui est présent en plus forte concentration dans le métal qui sera brasé sur la céramique. La technique d'implantation permet également, si nécessaire, d'implanter un ou plusieurs éléments simultanément.

Ce procédé d'ensemencement d'une surface céramique avec un ion par exemple métallique permet d'améliorer considérablement la qualité de la liaison entre ladite céramique et la brasure, en remplaçant une interface abrupte séparant deux matériaux antinomiques, en une interface à composition graduée, comprenant dans la matrice céramique, en inclusion, une quantité non négligeable d'ions "mouillants".

De la même manière, un ensemencement d'une surface d'une pièce métallique ou d'un cristal d'oxyde métallique permet d'améliorer la qualité de la liaison entre ledit métal et la brasure, lorsque la brasure et le métal n'ont pas entre eux une très bonne mouillabilité, ou encore entre le cristal et la brasure.

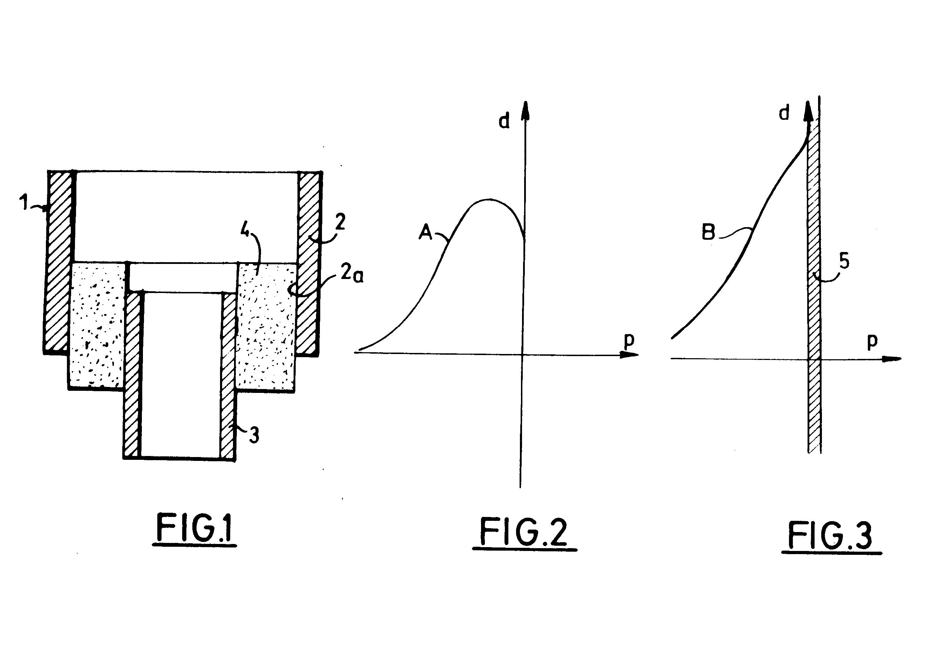

Dans l'exemple de réalisation de l'invention représenté sur la figure 1, on voit un ensemble 1 composé d'une pièce 2, en céramique, d'une pièce support 3 en alliage métallique, la pièce céramique et la pièce support étant liées entre elles par emmanchement.

La pièce céramique 2 peut être par exemple une alumine alors que l'alliage métallique constituant la pièce support 3 est un alliage de titane, TA6V.

Conformément au procédé de brasage selon l'invention, on implante dans la pièce 2 en céramique des ions de titane, sur la surface 2a de la pièce en contact avec une brasure 4.

Les ions titane sont implantés, selon une technique connue, sous une tension d'accélération comprise dans un intervalle de 10 à 300 KeV, avec une dose d'ions comprise entre $10^{15}$ à $10^{18}$ ions/cm$^2$.

La brasure 4 insérée entre la pièce céramique 2 et la pièce support 3 assemblées est un alliage à base d'argent.

Le titane peut être implanté selon deux modes de répartition, comme représenté sur les figures 2 et 3. La figure 2 montre une courbe A de répartition des ions en fonction de la profondeur p du matériau. La densité d d'ions la plus élevée est située dans la matrice de la pièce céramique 2, près de la surface de contact de la brasure 4.

La figure 3 montre une courbe B de répartition des ions, sur laquelle on voit que leur densité d la plus élevée en fonction de la profondeur p dans le matériau est située en surface de la pièce céramique.

Il peut être réalisé ainsi un film mince 5 de titane par une technique d'implantation appropriée, la brasure 4 mouillant alors une surface continue de métal lors de sa fusion.

On réalise avec le procédé selon l'invention une liaison par brasage entre la pièce céramique et la pièce support métallique, conférant une rigidité mécanique entre lesdites pièces, en particulier lorsque les matériaux des pièces sont incompatibles avec la brasure pour un manque de mouillabilité.

**Revendications**

1. Procédé pour réaliser une liaison par brasage entre deux pièces (2, 3) et notamment entre une pièce (2) en céramique et une pièce métallique (3), selon lequel on assemble les pièces à braser en interposant entre leurs surfaces en contact, une brasure (4) constituée d'un métal ou d'un alliage métallique dont le point de fusion est à une température moins élevée que le point de fusion des matériaux constituant les pièces à réunir, on élève la température de l'ensemble des pièces, afin de fondre la brasure, la brasure en fusion mouillant la surface en contact des pièces, on refroidit l'ensemble des pièces en contrôlant la température, afin de solidifier la brasure et de réaliser une ensemble rigide avec les pièces, muni d'un joint, caractérisé en ce qu'on implante des ions dans au moins une surface de contact d'une des pièces (2, 3) à joindre, préalablement à l'assemblage des pièces et à la brasure, pour améliorer la mouillabilité de la brasure sur la surface de contact implantée.

2. Procédé selon la revendication 1 caractérisé en ce que les ions implantés sont choisis parmi les ions.Ti, Al, Cr, Mn, Fe, Co, Ni, Cu, Ag, Au, Zr.

3. Procédé selon les revendications 1 et 2 caractérisé en ce qu'on implante les ions sur la surface de contact de pièces céramiques.

4. Procédé selon les revendications 1 et 2 caractérisé en ce qu'on implante les ions sur la surface de contact de pièces constituées d'un cristal d'oxyde métallique.

5. Procédé selon les revendications 1 et 2 caractérisé en ce qu'on implante les ions sur la surface de contact de pièces métalliques.

6. Procédé selon l'une des revendications 1 à 5, caractérisé en ce que les ions sont répartis majoritairement dans la matrice du matériau de la pièce implantée, près de la surface de contact (Fig.2).

7. Procédé selon l'une des revendications 1 à 6, caractérisé en ce que les ions sont répartis d'une part dans la matrice du matériau de la pièce et en surface de la pièce pour former un film (5) composé majoritairement des ions implantés (Fig.3).

8. Ensemble composé de pièces brasées et notamment composé d'une pièce céramique et d'une pièce métallique, caractérisé en ce qu'il est réalisé par la mise en oeuvre du procédé selon l'une quelconque des revendications 1 à 7.

9. Ensemble selon la revendication 8, composé d'une pièce (2) en céramique, d'une pièce (3) support de la pièce céramique, en métal ou alliage métallique, les pièces étant liées rigidement entre elles par un emmanchement, caractérisé en ce que dans l'emmanchement est inséré une brasure (4) liant mécaniquement la pièce céramique et la pièce support.

FIG.1　　　　　FIG.2　　　　　FIG.3

EP 0 500 454 A1

Office européen
des brevets

**RAPPORT DE RECHERCHE EUROPEENNE**

Numero de la demande

EP    92 40 0429

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | EP-A-0 252 049 (SANDVIK AKTIEBOLAG)<br>* colonne 2, ligne 12 - colonne 3, ligne 8 *<br>--- | 1-3 | B23K1/20<br>C23C14/48 |
| Y | US-A-4 894 255 (PAGE ET AL.)<br>* colonne 1, ligne 18 - colonne 4, ligne 31; figures 2-4 *<br>--- | 1-3 | |
| A | EP-A-0 356 111 (WELSCH)<br>* le document en entier *<br>--- | 1,2,5 | |
| A | PATENT ABSTRACTS OF JAPAN<br>vol. 8, no. 34 (C-210)(1471) 15 Février 1984<br>& JP-A-58 197 263 ( SUMITOMO DENKI KOGYO K.K. )<br>16 Novembre 1983<br>* abrégé *<br>----- | 1-6 | |
| | | | **DOMAINES TECHNIQUES RECHERCHES (Int. Cl.5)**<br><br>B23K<br>C23C |

Le présent rapport a été établi pour toutes les revendications

| Lieu de la recherche | Date d'achèvement de la recherche | Examinateur |
|---|---|---|
| LA HAYE | 27 MAI 1992 | HERBRETEAU D. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)